# EUROPÄISCHE PATENTSCHRIFT

(11) **EP 1 067 693 B1**
(45) Veröffentlichungstag und Bekanntmachung des Hinweises auf die Patenterteilung: **16.08.2006**
(21) Anmeldenummer: 00113819.7
(22) Anmeldetag: 29.06.2000
(51) Int. Cl.: H03L 7/107, H03L 7/095, H03L 7/18

(54) **PLL-Synthesizer**
PLL synthesizer
Synthétiseur à PLL

(30) Priorität: 30.06.1999 DE 19930225
(43) Veröffentlichungstag der Anmeldung: 10.01.2001
(73) Patentinhaber: Infineon Technologies AG, 81669 München (DE)
(72) Erfinder: Stepp, Richard, 80796 München (DE); Kröbel, Hans-Eberhard, 81735 München (DE)
(74) Vertreter: Epping - Hermann - Fischer

(56) Entgegenhaltungen:
- EP-A- 0 461 358
- EP-A- 0 727 877
- US-A- 5 128 632
- PATENT ABSTRACTS OF JAPAN vol. 1999, no. 09, 30. Juli 1999 (1999-07-30) & JP 11 122101 A (FUJITSU LTD;FUJITSU VLSI LTD), 30. April 1999 (1999-04-30)
- CORVISIER P: "LES CIRCUITS SYNTHETISEURS DE FREQUENCE POUR RADIOCOMMUNICATIONS" ELECTRONIQUE,FR,CEP COMMUNICATION, PARIS, Nr. 83, Juli 1998 (1998-07), Seiten 7-8,10, XP000846932 ISSN: 1157-1152

## Beschreibung

Die vorliegende Erfindung bezieht sich auf ein Verfahren zum Betrieb einer PLL-Synthesizerschaltung sowie auf eine PLL-Synthesizerschaltung.

PLL-Synthesizerschaltungen sind aus dem Stand der Technik gut bekannt.

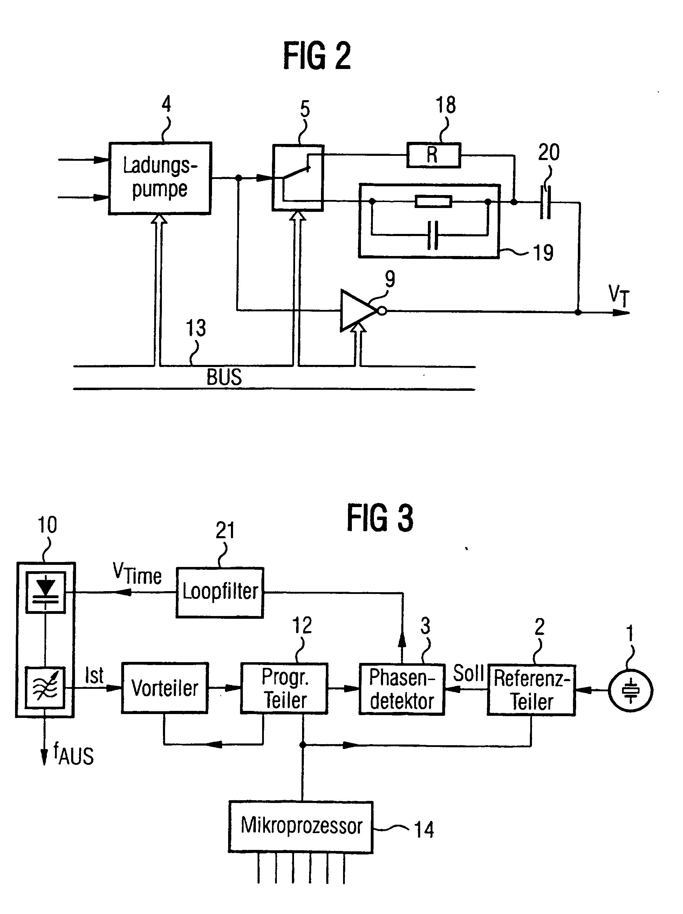

Unter Bezugnahme auf Figur 3 soll kurz das Prinzip einer solchen Schaltung erläutert werden. Ausgehend von der festen Referenzfrequenz eines Lokaloszillators (Quarz) 1 sollen wählbare Ausgangsfrequenzen an einem spannungsgesteuerten Oszillator (VCO) 10 bereitgestellt werden. Dazu wird das Referenzsignal von dem Lokaloszillator 1 einem programmierbaren Referenzteiler 2 zugeführt und das geteilte Referenzsignal dann zu einem Phasendetektor 3 geleitet. Der Phasendetektor 3 gibt ein Ausgangssignal proportional zu der erfaßten Differenz zwischen der Phase des geteilten Referenzsignals und der Phase eines von einem programmierbaren Teiler 12 her zugeführten Signals aus. Das Ausgangssignal des Phasendetektors 3 wird tiefpaßgefiltert (Loopfilter 21) und das tiefpaßgefilterte Spannungssignal wird dann dem VCO 10 zugeführt. Das Ausgangssignal des VCO 10 wird einmal als das gewünschte Signal abgeleitet und andererseits durch einen weiteren programmierbaren Teiler 12 geteilt dem Phasendetektor 3 zugeführt. Die Teilerwerte der programmierbaren Teiler 2 bzw. 12 können durch einen Mikroprozessor 14 angesteuert werden.

Durch eine Veränderung des Steuerwerts vom Mikroprozessor 14 werden die Teilerwerte der programmierbaren Teiler 2 bzw. 12 geändert. Nach jeder Frequenzänderung muß dann die Regelschleife neu einschwingen und schließlich einrasten. Diese Einstellzeit-Konstante wird beispielsweise durch die Verzögerung (Zeitkonstante) des Tiefpaß-Loopfilters 21 mitbestimmt. Als Faustregel kann gesagt werden, daß die Einstellzeit der Regelschleife zur "Einrastung" auf eine neue Frequenz etwa 100 Perioden der dem Phasendetektor 3 zugeführten geteilten Referenzfrequenz dauert. Bei einer Frequenz von 1 kHz sind dies beispielsweise 0,1 s.

Indessen kommt es bei Empfangssystemen mit PLL-Sythesizern unter anderem darauf an, den Frequenzwechsel so schnell wie möglich durchzuführen und gleichzeitig im Empfangszustand, das heißt bei festgehaltener Frequenz, einen größtmöglichen Signal-Störabstand (S/N) zu erreichen. Beide Bedingungen, nämlich schneller Frequenzwechsel und großer Signal-Störabstand sind normalerweise mit einem einzigen Loopfilter oder allgemein gesagt mit einer einzigen Zeitkonstante der PLL-Schleife nicht erreichbar. Daher ist es bekannt, Tiefpaß-Loopfilter mit verschiedenen Zeitkonstanten bereitzustellen, beispielsweise indem Tiefpaßfilter mit verschiedenen Zeitkonstanten parallel geschaltet durch eine Schalteinheit angewählt werden. Ein Problem ist dabei, daß dann jeder Wechsel der Zeitkonstanten in Audioempfangssystemen hörbar ist, da beim Umschalten ein Potentialausgleich erfolgt. Durch zwangsweise nachfolgende Mute-Maßnahmen wird der gewonnene Zeitvorteil durch die kleinere Zeitkonstante dann in der Regel wieder zunichte gemacht.

In der US-A-5 420 545 ist ein Frequenzsythesizer gezeigt, der im Rückkopplungspfad einen programmierbaren Teiler enthält, dessen Teilerfaktor über eine Steuerschaltung in Abhängigkeit von der gewünschten Ausgangsfrequenz veränderbar ist. Bei Frequenzänderung wird außerdem die Bandbreite des Schleifenfilters vergrößert, um ein schnelleres Einschwingen auf die neue Frequenz zu ermöglichen. Die Steuerungseinrichtung wird durch ein Frequenzwechselsignal hierzu veranlaßt. In der EP-A2-0 669 722 ist ein ähnlicher Phasenregelkreis gezeigt, bei dem die Zeitkonstante des Schleifenfilters bei einem Wechsel des Frequenzteilerverhältnisses verändert wird. Das Schleifenfilter enthält eine Schaltung mit veränderbarem Widerstand. Die Zeitkonstante des Schleifenfilters wird verringert, so daß ein Einrasten der PLL nach einem Frequenzwechsel beschleunigt wird. Bei einem anderen in der EP-A2-0 211 594 gezeigten Phasenregelkreis sind zwei Schleifenfilter vorgesehen, zwischen denen in Abhängigkeit von einem Wechsel des Frequenzteilerverhältnisses umgeschaltet wird.

In dem Dokument EP 0 461 358 A1 ist ein Frequenzsynthesizer angegeben. Dieser umfasst eine Steuerschaltung, die das Schleifenfilter und Frequenzteiler ansteuert, derart, dass während eines Frequenzwechselvorgangs sukzessive veschiedene Frequenzteilerverhältnisse und zugeordnete Filter aktiviert werden. Dadurch wird während des Frequenzwechselvorgangs die Ausgangsfrequenz des Oszillators inkrementell verändert. Bei einer Ausführung ist vorgesehen, mit einem zusätzlichen Phasensynchrondetektor am Eingang des Phasendetektors eine Phasensynchronität nach jedem Frequenzwechselvorgang zu erkennen.

Das Dokument US 5,128,632 betrifft einen Frequenzsynthesizer mit adaptiver Verriegelungszeitsteuerung. Ein Verriegelungsdetektor erkennt eingerastete und nicht eingerastete Zustände durch Bereitstellen eines Zählwerts, der die Phasendifferenz zwischen zwei Schleifensignalen angibt. Ein eingerasteter Zustand liegt vor, wenn der Zählwert einen vorbestimmten Zählwert übersteigt.

In der EP-A1-0 582 390 ist ein Phasenregelkreis gezeigt, bei dem in Abhängigkeit von dem vom Phasenkomparator bereitgestellten Phasenfehler zwischen zwei verschiedenen Schleifenfiltern umgeschaltet wird. Bei niedrigem Phasenfehler wird das Schleifenfilter mit geringer Bandbreite aktiviert, bei größerem Phasenfehler das Schleifenfilter mit großer Bandbreite.

Es sind weitere Möglichkeiten bekannt, den Frequenzwechsel zu beschleunigen. So kann beispielsweise der Strom der Ladungspumpe in der PLL-Schleife deutlich erhöht werden oder der Loopverstärker mit größerem Strom betrieben werden.

Aufgrund des oben angesprochenen Problems des Potentialabgleichs beim Umschalten von Zeitkonstanten beim Loopfilter (Schleifenfilter) beschränkt man sich beim Stand der Technik oft darauf, für den Frequenzwechselvorgang lediglich den Strom der Ladungspumpen zu erhöhen. Dies ist im eingeschwungenen Zustand der PLL ohne Störgeräusche möglich. Daher wird die Schaltung meist so optimiert, daß bei maximal erreichbaren S/N die erreichte Einschwingzeit einfach akzeptiert wird und nur auf Kosten des S/N weiter optimiert werden kann.

Es ist Aufgabe der vorliegenden Erfindung, eine Technik für PLL-Synthesizer bereitzustellen, die den Frequenzwechsel im Hinblick auf das Umschalten in die Frequenzwechsel-Betriebsart und das Zurückschalten in die Empfangs-Betriebsart verbessert.

Diese Aufgabe wird durch die Merkmale der unabhängigen Ansprüche 1 und 3 gelöst. Die abhängigen Ansprüche bilden den zentralen Gedanken der Erfindung in besonders vorteilhafter Weise weiter.

Es ist ein Verfahren zum Betrieb einer PLL-Synthesizerschaltung vorgeschlagen. Wie aus dem Stand der Technik bekannt kann die Ausgangsfrequenz der PLL-Synthesizerschaltung durch entsprechende Ansteuerung einer programmierbaren Teilerschaltung in einer Rückführschleife der PLL-Synthesizerschaltung gewählt werden. Die PLL-Synthesizerschaltung kann in einer Empfangs-Betriebsart (feste Frequenz) und wenigstens einer weiteren Betriebsart (Frequenzwechsel-Betrieb) betrieben werden. In der wenigstens einen weiteren Betriebsart weist die PLL-Synthesizerschaltung im Vergleich zu der Empfangs-Betriebsart eine verringerte Einschwing-Zeitkonstante auf, so daß der Frequenzwechsel verhältnismäßig zügig erfolgen kann. Die PLL-Synthesizerschaltung wird dabei in die wenigstens eine weitere Betriebsart (das heißt die eine Frequenzwechsel-Betriebsart mit kleiner Einschwing-Zeitkonstante) abhängig von einer Erfassung umgeschaltet, daß die programmierbare Teilerschaltung mit einem veränderten Wert angesteuert wird. Wenn nämlich durch entsprechende Ansteuerung der programmierbaren Teilerschaltung ein Frequenzwechsel ausgeführt wird, wird die Regelschleife aus ihrem eingeschwungenen Zustand gebracht und die Phasendifferenz wächst quasi unbegrenzt an. In diesem Zustand ist ein Empfang auf keinen Fall möglich, so daß auch beispielsweise die Zeitkonstante des Tiefpaßfilters verkleinert werden kann, da beim Frequenzwechsel auf einen großen Signal-Störabstand kein Wert gelegt werden muß. In die Empfangs-Betriebsart kann dann zurückgeschaltet werden, sobald die Phasendifferenz zwischen dem Ausgangssignal der programmierbaren Teilerschaltung und einer Referenzfrequenz einen vorgegebenen Schwellenwert unterschreitet. Zum Zurückschalten in den Empfangs-Betriebsmodus wird also an einer anderen Stelle in der PLL-Schleife angesetzt als zum Auslösen des Frequenzwechsel-Modus.

Das Umschalten in die Frequenzwechsel-Betriebsart wird nicht durch Erfassen des Überschreitens eines vorbestimmten Grenzwerts durch die Phasendifferenz ausgelöst. Die Phasendifferenz kann nämlich auch ohne erwünschten Frequenzwechsel durch Störeinflüsse auf die PLL-Schleife den vorbestimmten Grenzwert überschreiten. Somit würde in diesem Fall unnötigerweise der Frequenzwechsel-Modus initiiert werden. Der Frequenzwechsel-Modus wird nur initiiert, wenn tatsächlich ein Frequenzwechsel durch entsprechende Ansteuerung des programmierbaren Teilers ausgeführt werden soll.

Wenn der Wechsel in den Frequenzwechsel-Modus initiiert wurde, kann zusätzlich wenigstens einer der folgenden Schritte ausgeführt werden:
a) Der Strom einer Ladungspumpe der PLL-Synthesizerschaltung kann erhöht werden,
b) der Strom eines Schleifenverstärkers der PLL-Synthesizerschaltung kann erhöht werden,
c) die programmierbare Teilerschaltung sowie eine programmierbare Referenz-Teilerschaltung zwischen einem Referenzoszillator und einem Phasendetektor der PLL-Synthesizerschaltung können jeweils auf eine höhere Frequenz angesteuert werden, wodurch dem Phasendetektor Signale mit gesteigerter Frequenz zugeführt werden.

Wie bereits eingangs gesagt, hängt die Einstellzeit der PLL-Schleife bis zur Einrastung unter anderem von der dem Phasendetektor zugeführten Frequenzen ab. Durch Erhöhung dieser Frequenzen kann somit die Einstellzeit verringert werden.

Erfindungsgemäß ist weiterhin eine PLL-Synthesizerschaltung gemäß Anspruch 3 vorgesehen. Diese PLL-Synthesizerschaltung weist eine programmierbare Teilerschaltung auf, die von der Steuerung zur Wahl einer gewünschten Ausgangsfrequenz der PLL-Synthesizerschaltung angesteuert wird. Eine Betriebsart-Wahlschaltung steuert wahlweise eine Empfangs-Betriebsart und wenigstens eine weitere Betriebsart (Frequenzwechsel-Betriebsart) der PLL-Synthesizerschaltung an, wobei die PLL-Synthesizerschaltung in der Frequenzwechsel-Betriebsart im Vergleich zu der Empfangs-Betriebsart eine verringerte Einschwing-Zeitkonstante aufweist.

Es sind Mittel zur Erfassung der Ansteuerung der programmierbaren Teilerschaltung durch die Steuerung mit einem veränderten Ansteuerwert vorgesehen, die ein Erfassungssignal an die Betriebsart-Wahlschaltung ausgeben, das letztere zur Ansteuerung der wenigstens einen weiteren Betriebsart (Frequenzwechsel-Betriebsart) veranlaßt.

Ein Phasendetektor und ein Verriegelungs-Erfassungsmittel ist vorgesehen, wobei die Verriegelungs-Erfassungsmittel das Ausgangssignal des Phasendetektors mit einem Schwellenwert vergleichen und für den Fall, daß das Ausgangssignal des Phasendetektors den Schwellenwert unterschreitet, ein Verriegelungssignal an die Betriebsart-Wahlschaltung ausgeben, das letztere zur Ansteuerung der Empfangs-Betriebsart veranlaßt.

Zur Verringerung der Einschwing-Zeitkonstanten der PLL-Synthesizerschaltung in der wenigstens einen weiteren Betriebsart (Frequenzwechsel-Betriebsart) kann zusätzlich eine Ladungspumpe vorgesehen sein, deren Strom in der wenigstens einen weiteren Betriebsart (Frequenzwechsel-Betriebsart) erhöht werden kann.

Zusätzlich kann der Strom, mit dem ein Schleifenverstärker betrieben wird, in der Frequenzwechsel-Betriebsart erhöht werden.

Zusätzlich kann ein Schleifenfilter mit wählbarer Zeitkonstante vorgesehen sein, wobei die Zeitkonstante in der Frequenzwechsel-Betriebsart verringert wird.

Zusätzlich kann zur Verringerung der Einschwing-Zeitkonstanten der PLL-Synthesizerschaltung in der wenigstens einen weiteren Betriebsart (Frequenzwechsel-Betriebsart) eine programmierbare Referenz-Teilerschaltung zwischen einem Referenzoszillator und einem Phasendetektor der PLL-Synthesizerschaltung vorgesehen sein, die in der wenigstens einen weiteren Betriebsart (Frequenzwechsel-Betriebsart) durch die Betriebsart-Wahlschaltung zusammen mit der programmierbaren Teilerschaltung jeweils auf ein höhere Frequenz angesteuert wird.

Es können zwei parallele Schleifenfilter mit unterschiedlichen Zeitkonstanten vorgesehen sein, wobei in dem Empfangsmodus ein Schalter das Schleifenfilter mit der größeren Zeitkonstante wählt.

Zwischen den beiden Schleifenfiltern kann zum Potentialabgleich ein hochohmiger Widerstand geschaltet sein. Somit läßt sich das Problem des "Knackens", das heißt des hörbaren Potentialabgleichs bei Audioempfangssystemen vermeiden.

Alternativ kann zur Veränderung der Zeitkonstante eines Schleifenfilters ein Widerstand durch eine Schalteinheit parallel zu einem Schleifenfilter schaltbar sein. In diesem Fall ist also die Schalteinheit kein Wechselschalter, vielmehr wird der parallel geschaltete Widerstand nur zu- bzw. abgeschaltet. Auch in diesem Fall besteht das Problem des Potentialabgleichs, das zu einem hörbaren Knack-Geräusch führen kann, nicht.

Weitere Merkmale, Eigenschaften und Vorteile der vorliegenden Erfindung werden aus der folgenden Beschreibung von Ausführungsbeispielen und unter Bezugnahme auf die Figuren der begleitenden Zeichnungen näher ersichtlich.
- Figur 1: zeigt eine PLL-Synthesizerschaltung gemäß einem Ausführungsbeispiel der vorliegenden Erfindung,
- Figur 2: zeigt einen Ausschnitt der PLL-Synthesizerschaltung von Figur 1 gemäß einem weiteren Ausführungsbeispiel, und
- Figur 3: zeigt eine allgemein bekannte PLL-Synthesizerschaltung gemäß dem Stand der Technik.

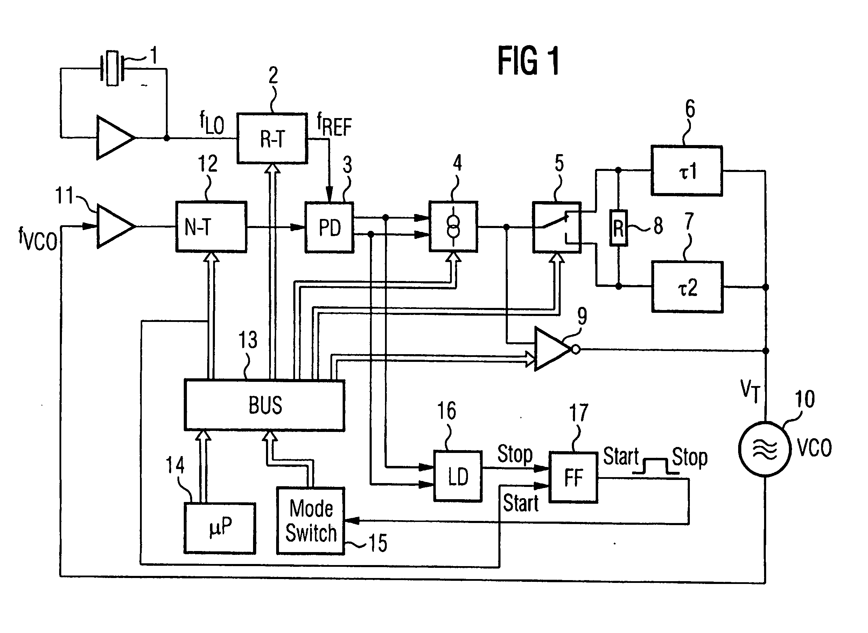

Bezugnehmend auf Figur 1 soll zuerst die erfindungsgemäße PLL-Synthesizerschaltung erläutert werden. Von einem Quarz 1 wird eine Lokaloszillator-Frequenz f_{LO} zu einem Referenz-Teiler 2 geführt. Dieser Referenz-Teiler 2 ist ein programmierbarer Teiler, wobei die Programmierung beispielsweise ausgehend von einem Mikroprozessor 14 der Steuereinheit über einen Bus 13 erfolgen kann.

Die geteilte Ausgangsfrequenz f_{REF} des Referenz-Teilers 2 wird dem Phasendetektor 3 zugeführt. Das Ausgangssignal des Phasendetektors 3 wird einer Ladungspumpe 4 zugeführt. Die Ladungspumpe (Stromquelle/-senke) gibt ein Ausgangssignal zu einer Tiefpaß-Schleifenfiltereinheit, die wenigstens zwei verschiedene Schleifenfilter 6, 7 aufweist. Durch eine Schalteinheit 5, die ebenfalls mittels des Busses 13 angesteuert, kann ausgewählt werden, ob das Schleifenfilter 6 mit der kleineren Zeitkonstante t₁ oder das Schleifenfilter 7 mit der größeren Zeitkonstanten t₂ geschaltet werden soll. Zum Potentialabgleich und zur Vermeidung von hörbaren Knackgeräuschen beim Umschaltvorgang ist ein Widerstand 8 eingangsseitig zwischen die Schleifenfilter 6, 7 geschaltet. Weiterhin ist ein Schleifenverstärker (Loopverstärker) 9 vorgesehen, der unter anderem notwendig ist, um den Spannungshub von beispielsweise 0,5 bis 4,5 V der Ladungspumpe 4 auf den höheren Spannungshub von beispielsweise 0 bis 7 V umzusetzen, der beispielsweise von einem VCO 10 für UKW-Anwendungen benötigt wird.

Der Strom durch die Ladungspumpe 4 sowie der Strom, mit dem der Schleifenverstärker 9 betrieben wird, können ebenfalls mittels des Busses 13 gesteuert durch beispielsweise den Mikroprozessor 14 gewählt werden.

Das von VCO 10 abhängig von der zugeführten Abstimmspannung V_{T} erzeugte Signal mit der Frequenz f_{VCO} wird gegebenenfalls nochmals verstärkt durch einen Verstärker 11 und dann einem programmierbaren Teiler 12 zugeführt. Das durch den programmierbaren Teiler 12 geteilte Signal wird dem Phasendetektor 3 zugeführt, der die Phase dieses Signals mit der Phase des Signals von dem Referenzteiler 2 her vergleicht.

Der Teilerwert des Referenzteilers 2 sowie der Teilerwert des Schleifen-Teilers 12 kann ebenfalls mittels des Busses 13 beispielsweise angesteuert durch den Mikroprozessor 14 gewählt werden. Der Mikroprozessor 14 steuert mittels des Busses 13 die Teilerschaltungen 2 bzw. 12 beispielsweise für den Fall eines Frequenzwechsels an.

Wie bereits eingangs ausgeführt, soll für den Fall eines Frequenzwechsels, der durch den Mikroprozessor 14 initiiert wird, die Einstellzeit-Konstante der PLL-Synthesizerschaltung verringert werden. Dazu können verschiedene Maßnahmen getroffen werden, die später erläutert werden.

Zuerst soll dargestellt werden, wie gemäß der Erfindung der Frequenzwechsel-Modus mit verringerter Einstellzeit initiiert wird. Wie bereits erwähnt, steuert der Mikroprozessor 14 mittels des Busses 13 für einen Frequenzwechsel den Schleifenteiler 12 mit einem neuen Ansteuerwert an. Dieser veränderte Ansteuerwert wird durch einen Trigger 17 erfaßt, der bei dieser Erfassung eines neuen Ansteuerwerts für den Schleifenteiler 12 ein Startsignal an einen Modusschalter (mode switch) 15 gibt. Der Modus-Wechselschalter 15, der also zwischen der Frequenzwechsel-Betriebsart sowie der Empfangs-Betriebsart hin und her schalten kann, gibt dann entsprechende Umschaltsignale über den Bus 13 an verschiedene Bauteile der PLL-Synthesizerschaltung aus.

Zum Zurückwechseln von dem Frequenzwechsel-Betriebsmodus in den Empfangs-Betriebsmodus erfaßt ein Verriegelungsdetektor 16 die Phasendifferenz, die von dem Phasendetektor 3 ausgegeben wird. Sobald diese Phasendifferenz dem Frequenzwechsel-Betriebsmodus wieder unter einen vorgegebenen Schwellenwert gefallen ist und somit die PLL-Synthesizerschaltung insgesamt wieder eingeschwungen ist, gibt der Verriegelungsdetektor 16 ein Stopsignal an den Trigger 17, der ein dementsprechendes Ausgangssignal, das heißt ein Verriegelungs-Erfassungssignal an den Modusschalter 15 gibt, der mittels des Busses 13 dann die verschiedenen Bauteile der PLL-Synthesizerschaltung wieder auf Parameter für die Empfangs-Betriebsart umschalten kann.

Die Auslösung des Wechsels in den Frequenzwechsel-Modus durch Erfassung einer veränderten Ansteuerung des Schleifenteilers 12 hat mehrere Vorteile. Zum einen ist eine veränderte Ansteuerung des Schleifenteilers 12 ein eindeutiger Hinweis für einen gewollten Frequenzwechsel. Darüber hinaus wird der Wechsel in den Frequenzwechsel-Modus unabhängig von beispielsweise durch Störfälle auftretende Phasenfehler am Ausgang des Phasendetektors 3, wobei das System insgesamt stabiler wird.

Der Betriebsartschalter (mode switch) 15 kann auch mittels des Busses 13 die Parameter von verschiedenen Bauteilen der Synthesizerschaltung insgesamt oder nur teilweise verändern, so daß neben Empfangs(Standard)-Modus auch verschiedene Frequenzwechsel-Modi (fast modes) ermöglicht werden.

Grundsätzlich sind für den Wechsel in den Frequenzwechsel-Modus (fast mode) folgende Parameterveränderungen in der PLL-Synthesizerschaltung möglich:

Wie bereits ausgeführt kann durch die Schalteinheit 5 ein Umschalten von dem Schleifenfilter 7 mit großer Zeitkonstante Tau₂ auf das Schleifenfilter 6 mit kleiner Zeitkonstante Tau₁ erfolgen. Dadurch verschlechtert sich zwar gleichzeitig der Signal-Rauschabstand, indessen spielt dies während des Frequenzwechselmodus keine Rolle.

Weiterhin kann in dem Frequenzwechselmodus der Strom, mit dem der Schleifenverstärker 9 betrieben wird, erhöht werden. Darüber hinaus kann auch der Strom durch die Ladungspumpe 4 erhöht werden. Schließlich können die Teilerschaltungen 2 bzw. 12 auf einen geringeren Teilerwert hin angesteuert werden (ausgelöst durch den mode switch 15), so daß dem Phasendetektor 3 Signale mit höheren Frequenzen zugeführt werden.

Figur 2 zeigt einen Ausschnitt einer PLL-Synthesizerschaltung gemäß einem weiteren Ausführungsbeispiel der Erfindung. Dieses Ausführungsbeispiel weist im Bereich der Schleifenfilter Unterschiede zu dem Ausführungsbeispiel von Figur 1 auf. Wie in Figur 2 ersichtlich ist gemäß diesem Ausführungsbeispiel ein Schleifenfilter 19, 20 immer aktiv. In dem FrequenzWechselmodus ist nur dieses Schleifenfilter 19, 20 wirksam. Für den Fall des Empfangs-Modus schaltet die Schalteinheit 5 ausgelöst durch ein Signal von dem Bus 13 einen Widerstand 18 parallel zu dem Schleifenfilter 19, 20, so daß die Dämpfung und somit auch die Zeitkonstante des Schleifenfilters insgesamt erhöht werden. Somit verbessert sich auch unter Inkaufnahme eines Geschwindigkeitsverlustes der Signal-Rauschabstand, wie es natürlich im Empfangszustand erwünscht ist.

In dem Ausführungsbeispiel von Figur 2 ist ebenso wie durch den Widerstand gemäß dem Ausführungsbeispiel von Figur 1 dargestellt, daß zwischen den beiden Zweigen des Loopfilters das jeweils anliegende Potential übertragen und somit abgeglichen wird. Dies ermöglicht ein störungsfreies Umschalten.

Selbstverständlich sind zwei oder mehr Zeitkonstanten durch entsprechendes Vorsehen von Schleifenfiltern umschaltbar an einer einzigen Ladungspumpe und an demselben Ausgang des Loopverstärkers anschließbar. Somit ergibt sich ein minimaler externer Schaltungsaufwand. Der Betriebszustand (Empfangszustand), in dem ein maximaler Signal-Störabstand gefordert wird, und die Einschwingzeit im Falle des Frequenzwechsel-Modus sind getrennt voneinander und unabhängig optimierbar. Bei der Umschaltung des Loopverstärkerstroms zur Verkürzung der Einschwingzeit bleiben die optimalen Bedingungen am Ausgang der Ladungspumpe (vorzugsweise V_{DD}/2) erhalten.

Der integrierte Loopverstärker kann wahlweise über die steuerbare Stromquelle (Ladungspumpe) so eingestellt werden, daß in Kombination mit den Strömen der Ladungspumpe und einem ausgewählten Schleifenfilter sowohl ein Maximum an Signal-Störabstand wie auch eine minimale Einschwingzeit der PLL-Synthesizerschaltung erreicht wird. Beide Zustände sind jeweils einzeln optimierbar.

Bevorzugte Anwendungsgebiete für die dargestellte PLL-Synthesizerschaltung sind Autoradios, TV-Geräte sowie Mobilfunkanwendungen.

## Patentansprüche

1. Verfahren zum Betrieb einer PLL-Synthesizerschaltung, deren Ausgangsfrequenz (f_{VCO}) durch entsprechende Ansteuerung einer programmierbaren Teilerschaltung (12) in einer Rückführschleife der PLL-Synthesizerschaltung gewählt werden kann, wobei ein Phasendetektor (3) eine Phasendifferenz zwischen einem von der programmierbaren Teilerschaltung (12) abgegebenen Signal und einem Signal mit einer Referenzfrequenz (f_{REF}) bereitstellt, wobei die PLL-Synthesizerschaltung in beiner Empfangs-Betriebsart und wenigstens einer weiteren Betriebsart betrieben werden kann, in der die PLL-Synthesizerschaltung im Vergleich zu der Empfangs-Betriebsart eine verringerte Einschwing-Zeitkonstante aufweist, und
in die Empfangs-Betriebsart geschaltet wird, sobald die von dem Phasendetektor als Ausgangssignal bereitgestellte Phasendifferenz (3) zwischen dem Ausgangssignal der programmierbaren Teilerschaltung (12) und der Referenzfrequenz (f_{REF}) bei Vergleich mittels Verriegelungs-Erfassungsmitteln (16) einen vorgegebenen Schwellenwert unterschreitet,
**dadurch gekennzeichnet, daß**
die PLL-Synthesizerschaltung in die wenigstens eine weitere Betriebsart abhängig von einem an eine Betriebsart-Wahlschaltung (15) von Mitteln (17) ausgegebenen Erfassungssignal umgeschaltet wird, wobei die Mittel (17) einen veränderten Ansteuerwert der programmierbaren Teilesrchaltung (12) erfassen, die durch eine Steuerung (14) mit dem veränderten Ansteuerwert angesteuert wird, und
daß bei dem Umschalten in die wenigstens eine weitere Betriebsart zur Verringerung der Einschwing-Zeitkonstante der PLL-Synthesizerschaltung die Zeitkonstante eines Schleifenfilters (6, 7) der PLL-Synthesizerschaltung verringert wird.

2. Verfahren nach Anspruch 1,
**dadurch gekennzeichnet,**
**daß** bei dem Umschalten in die wenigstens eine weitere Betriebsart zur Verringerung der Einschwing-Zeitkonstanten der PLL-Synthesizerschaltung zusätzlich wenigstens einer der folgenden Schritte ausgeführt wird:
- Erhöhung des Stroms einer Ladungspumpe (4) der PLL-Synthesizerschaltung,
- Erhöhung des Stroms eines Schleifenverstärkers (9) der PLL-Synthesizerschaltung,
- Ansteuerung der programmierbaren Teilerschaltung (12) sowie einer programmierbaren Referenz-Teilerschaltung (2), die zwischen einem Referenzoszillator (1) und dem Phasendetektor (3) der PLL-Synthesizerschaltung geschaltet ist, jeweils auf eine höhere Frequenz.

3. PLL-Synthesizerschaltung, aufweisend
- eine programmierbare Teilerschaltung (12), die von einer Steuerung (14) zur Wahl einer gewünschten Ausgangsfrequenz (fvco) der PLL-Synthesizerschaltung angesteuert wird,
- eine Betriebsart-Wahlschaltung (15), die wahlweise eine Empfangs-Betriebsart und wenigstens eine weitere Betriebsart der PLL-Synthesizerschaltung ansteuert, in der die PLL-Synthesizerschaltung im Vergleich zu der Empfangs-Betriebsart verringerte Einschwing-Zeitkonstante aufweist,
- einen Phasendetektor (3) zur Bereitstellung einer Phasenabweichung zwischen einem von der programmierbaren Teilerschaltung (12) bereitgestellten Signal und einem Signal mit einer Referenzfrequenz (f_{REF}), und
- dem Phasendetektor (3) nachgeschaltete Verriegelungs-Erfassungsmittel (16), die das Ausgangssignal des Phasendetektors (3) mit einem Schwellenwert vergleichen und für den Fall, daß das Ausgangssignal des Phasendetektors (3) den Schwellenwert unterschreitet, ein Verriegelungssignal an die Betriebsart-Wahlschaltung (15) ausgeben, das letztere zur Ansteuerung der Empfangs-Betriebsart veranlaßt,
**gekennzeichnet durch**
- Mittel (17) zur Erfassung eines veränderten Ansteuerwerts der programmierbaren Teilerschaltung (12), die **durch** die Steuerung (14) mit dem veränderten Ansteuerwert angesteuert wird, wobei die Mittel (17) ein Erfassungssignal an die Betriebsart-Wahlschaltung (15) bei der Erfassung des veränderten Ansteuerwerts ausgeben, das letztere zur An- steuerung der wenigstens einen weiteren Betriebsart veranlaßt, wobei zur Verringerung der Einschwing-Zeitkonstanten der PLL-Synthesizerschaltung in der wenigstens einen weiteren Betriebsart ein Schleifenfilter (6, 7) mit wählbarer Zeitkonstanten vorgesehen ist, dessen Zeitkonstante in der wenigstens einen weiteren Betriebsart verringert wird.

4. PLL-Synthesizerschaltung nach Anspruch 3,
**dadurch gekennzeichnet,**
**daß** zur Verringerung der Einschwing-Zeitkonstante der PLL-Synthesizerschaltung in der wenigstens einen weiteren Betriebsart zusätzlich eine Ladungspumpe (4) vorgesehen ist, deren Strom in der wenigstens einen weiteren Betriebsart erhöht wird.

5. PLL-Synthesizerschaltung nach Anspruch 3 oder 4,
**dadurch gekennzeichnet,**
**daß** zur Verringerung der Einschwing-Zeitkonstanten der PLL-Synthesizerschaltung in der wenigstens einen weiteren Betriebsart zusätzlich ein Schleifenverstärker (9) vorgesehen ist, deren Strom in der wenigstens einen weiteren Betriebsart erhöht wird.

6. PLL-Synthesizerschaltung nach einem der Ansprüche 3 bis 5,
**dadurch gekennzeichnet,**
**daß** zur Verringerung der Einschwing-Zeitkonstanten der PLL-Synthesizerscheltun in der wenigstens einen weiteren Betriebsart zusätzlich eine programmierbare Referenz-Teilerschaltung (2), vorgesehen ist, die zwischen einem Referenzoszillator (1) und einem Phasendetektor (3) der PLL-Synthesizerschaltung geschaltet ist, und die in der wenigstens einen weiteren Betriebsart durch die Betriebsart-Wahlschaltung (15) zusammen mit der programmierbaren Teilerschaltung (12) jeweils auf eine höhere Frequenz angesteuert wird.

7. PLL-Synthesizerschaltung nach einem der Ansprüche 3 bis 5,
**dadurch gekennzeichnet,**
**daß** zwei parallele Schleifenfilter (6, 7) mit unterschiedlichen Zeitkonstanten vorgesehen sind, wobei in dem Empfangsmodus ein Schalter (5) das Schleifenfilter mit der größeren Zeitkonstante wählt.

8. PLL-Synthesizerschaltung nach Anspruch 7,
**dadurch gekennzeichnet,**
**daß** zwischen den beiden Schleifenfiltern (6, 7) ein hochohmiger Widerstand (8) geschaltet ist.

9. PLL-Synthesizerschaltung nach einem der Ansprüche 3 bis 5,
**dadurch gekennzeichnet,**
**daß** zur Veränderung der Zeitkonstante eines Schleifenfilters (18, 19) ein Widerstand (18) durch eine Schalteinheit (5) parallel zu einem Schleifenfilter (19, 20) schaltbar ist.

## Claims

1. Method for operating a PLL synthesizer circuit whose output frequency (f_{VCO}) can be selected by appropriately driving a programmable divider circuit (12) in a feedback loop of the PLL synthesizer circuit, a phase detector (3) providing a phase difference between a signal output by the programmable divider circuit (12) and a signal at a reference frequency (f_{REF}), it being possible to operate the PLL synthesizer circuit in a receive operating mode and at least one further operating mode in which the PLL synthesizer circuit has a settling time constant which is reduced by comparison with the receive operating mode, and
a switch is made into the receive operating mode as soon as the phase difference (3), provided by the phase detector as output signal, between the output signal of the programmable divider circuit (12) and the reference frequency (f_{REF}) undershoots a prescribed threshold value upon comparison by means of interlocking detecting means (16), **characterized in that** the PLL synthesizer circuit is changed over into the at least one further operating mode as a function of a detection signal output by means (17) to an operating mode selector circuit (15), the means (17) detecting an altered drive value of the programmable divider circuit (12) which is driven by a controller (14) and the altered drive value, and **in that** during the changeover into the at least one further operating mode the time constant of a loop filter (6, 7) of the PLL synthesizer circuit is reduced in order to reduce the settling time constant of the PLL synthesizer circuit.

2. Method according to Claim 1, **characterized in that** during the changeover into the at least one further operating mode for the purpose of reducing the settling time constant of the PLL synthesizer circuit at least one of the following steps is additionally executed:
- increasing the current of a charge pump (4) of the PLL synthesizer circuit,
- increasing the current of a loop amplifier (9) of the PLL synthesizer circuit,
- driving the programmable divider circuit (12) and a programmable reference divider circuit (2), which is connected between a reference oscillator (1) and a phase detector (3) of the PLL synthesizer circuit, to a higher frequency in each case.

3. PLL synthesizer circuit having
- a programmable divider circuit (12) which is driven by a controller (14) for selecting a desired output frequency (f_{VCO}) of the PLL synthesizer circuit,
- an operating mode selector circuit (15) which optionally drives a receive operating mode and at least one further operating mode of the PLL synthesizer circuit, in which the PLL synthesizer circuit has a settling time constant which is reduced by comparison with the receive operating mode,
- a phase detector (3) for providing a phase deviation between a signal provided by the programmable divider circuit (12) and a signal at a reference frequency (f_{REF}), and
interlocking detecting means (16), downstream of the phase detector (3), which compare the output signal of the phase detector (3) with a threshold value and, for the case in which the output signal of the phase detector (3) undershoots the threshold value, outputs an interlocking signal to the operating mode selector circuit (15) which prompts the latter to trigger the receive operating mode,
**characterized by** means (17) for detecting an altered drive value of the programmable divider circuit (12) which is driven by the controller (14) with the aid of the altered drive value, upon detection of the altered drive value the means (17) outputting to the operating mode selector circuit (15) a detection signal that prompts the latter to trigger the at least one further operating mode, in order to reduce the settling time constant of the PLL synthesizer circuit in the at least one further operating mode a loop filter (6, 7) with selectable time constant being provided, the time constant of which is reduced in the at least one further operating mode.

4. PLL synthesizer circuit according to Claim 3, **characterized in that** for the purpose of reducing the settling time constant of the PLL synthesizer circuit in the at least one further operating mode a charge pump (4) is additionally provided whose current is increased in the at least one further operating mode.

5. PLL synthesizer circuit according to Claim 3 or 4, **characterized in that** for the purpose of reducing the settling time constant of the PLL synthesizer circuit in the at least one further operating mode a loop amplifier (9) is additionally provided whose current is increased in the at least one further operating mode.

6. PLL synthesizer circuit according to one of Claims 3 to 5, **characterized in that** for the purpose of reducing the settling time constant of the PLL synthesizer circuit in the at least one further operating mode a programmable reference divider circuit (2) is additionally provided which is connected between a reference oscillator (1) and a phase detector (3) of the PLL synthesizer circuit and which is driven in each case to a higher frequency in the at least one further operating mode by the operating mode selector circuit (15) together with the programmable divider circuit (12).

7. PLL synthesizer circuit according to one of Claims 3 to 5, **characterized in that** two parallel loop filters (6, 7) with different time constants are provided, a switch (5) selecting the loop filter with the larger time constant in the receive mode.

8. PLL synthesizer circuit according to Claim 7, **characterized in that** a high-resistance resistor (8) is connected between the two loop filters (6, 7).

9. PLL synthesizer circuit according to one of Claims 3 to 5, **characterized in that** for the purpose of changing the time constant of a loop filter (18, 19) it is possible to connect a resistor (18) in parallel with a loop filter (19, 20) by means of a switching unit (5).

## Revendications

1. Procédé pour faire fonctionner un circuit synthétiseur à PLL dont la fréquence de sortie (f_{VCO}) peut être choisie par une commande correspondante d'un circuit diviseur programmable (12) dans une boucle de rétroaction du circuit synthétiseur à PLL, un détecteur de phase (3) fournissant une différence de phase entre un signal délivré par le circuit diviseur programmable (12) et un signal avec une fréquence de référence (f_{REF}), le circuit synthétiseur à PLL pouvant fonctionner dans un mode de réception et dans au moins un autre mode dans lequel le circuit synthétiseur à PLL a une constante de temps de période transitoire réduite par rapport à celle du mode de réception ; et une commutation dans le mode de réception étant effectuée dès que la différence de phase (3), fournie comme signal de sortie par le détecteur de phase, entre le signal de sortie du circuit diviseur programmable (12) et la fréquence de référence (f_{REF}) devient inférieure à une valeur de seuil prédéterminée lors de la comparaison par les moyens de détection de verrouillage (16),
**caractérisé par le fait que**
l'on commute le circuit synthétiseur à PLL dans le ou les autres modes en fonction d'un signal de détection délivré par des moyens (17) à un circuit de sélection de mode (15), les moyens (17) détectant une valeur de commande modifiée du circuit diviseur programmable (12) qui est commandé par une commande (14) avec la valeur de commande modifiée, et
lors de la commutation dans le ou les autres modes, on réduit la constante de temps d'un filtre de boucle (6, 7) du circuit synthétiseur à PLL pour réduire la constante de temps de période transitoire du circuit synthétiseur à PLL.

2. Procédé selon la revendication 1,
**caractérisé par le fait que**,
lors de la commutation dans le ou les autres modes, on exécute en plus au moins l'une des étapes suivantes pour réduire la constante de temps de période transitoire du circuit synthétiseur à PLL :
- augmentation du courant d'une pompe de charge (4) du circuit synthétiseur à PLL,
- augmentation du courant d'un amplificateur de boucle (9) du circuit synthétiseur à PLL,
- commande du circuit diviseur programmable (12) ainsi que d'un circuit diviseur de référence programmable (2), qui est branché entre un oscillateur de référence (1) et le détecteur de phase (3) du circuit synthétiseur à PLL, à chaque fois pour atteindre une fréquence supérieure.

3. Circuit synthétiseur à PLL, comportant :
- un circuit diviseur programmable (12), qui est commandé par une commande (14) pour la sélection d'une fréquence de sortie souhaitée (F_{VCO}) du circuit synthétiseur à PLL,
- un circuit de sélection de mode (15), qui commande sélectivement un mode de réception et au moins un autre mode du circuit synthétiseur à PLL, autre mode dans lequel le circuit synthétiseur à PLL a une constante de temps de période transitoire réduite par rapport à celle du mode de réception,
- un détecteur de phase (3), pour fournir un écart de phase entre un signal délivré par le circuit diviseur programmable (12) et un signal avec une fréquence de référence (f_{REF}),
- des moyens de détection de verrouillage (16), qui sont branchés du côté aval du détecteur de phase (3), qui comparent le signal de sortie du détecteur de phase (3) à une valeur de seuil et qui, si le signal de sortie du détecteur de phase (3) devient inférieur à la valeur de seuil, délivrent au circuit de sélection de mode (15) un signal de verrouillage qui invite ce circuit de sélection de mode à commander le mode de réception,
**caractérisé par**
- des moyens (17) pour la détection d'une valeur de commande modifiée du circuit diviseur programmable (12) qui est commandé par la commande (14) avec la valeur de commande modifiée, les moyens (17) délivrant au circuit de sélection de mode (15) lors de la détection de la valeur de commande modifiée un signal de détection qui invite ce circuit de sélection de mode à commander le ou les autres modes,
un filtre de boucle (6, 7) avec constante de temps sélectionnable, dont la constante de temps dans le ou les autres modes est réduite, étant prévu pour réduire la constante de temps de période transitoire du circuit synthétiseur à PLL dans le ou les autres modes.

4. Circuit synthétiseur à PLL selon la revendication 3,
**caractérisé par le fait que**, pour réduire la constante de temps de période transitoire du circuit synthétiseur à PLL dans le ou les autres modes, il est prévu en plus une pompe de charge (4) dont le courant dans le ou les autres modes est augmenté.

5. Circuit synthétiseur à PLL selon la revendication 3
ou 4,
**caractérisé par le fait que**, pour réduire la constante de temps de période transitoire du circuit synthétiseur à PLL dans le ou les autres modes, il est prévu en plus un amplificateur de boucle (9) dont le courant dans le ou les autres modes est augmenté.

6. Circuit synthétiseur à PLL selon l'une des revendications 3 à 5,
**caractérisé par le fait que**, pour réduire la constante de temps de période transitoire du circuit synthétiseur à PLL dans le ou les autres modes, il est prévu en plus un circuit diviseur de référence programmable (2) qui est branché entre un oscillateur de référence (1) et un détecteur de phase (3) du circuit synthétiseur à PLL et qui est commandé dans le ou les autres modes par le circuit de sélection de mode (15) conjointement avec le circuit diviseur programmable (12) à chaque fois pour atteindre une fréquence supérieure.

7. Circuit synthétiseur à PLL selon l'une des revendications 3 à 5,
**caractérisé par le fait qu'**il est prévu deux filtres de boucle parallèles (6, 7) avec des constantes de temps différentes, un interrupteur (5) choisissant dans le mode de réception le filtre de boucle ayant la plus grande constante de temps.

8. Circuit synthétiseur à PLL selon la revendication 7,
**caractérisé par le fait qu'**une résistance de grande valeur ohmique (8) est branchée entre les deux filtres de boucle (6, 7).

9. Circuit synthétiseur à PLL selon l'une des revendications 3 à 5,
**caractérisé par le fait que**, pour modifier la constante de temps d'un filtre de boucle (18, 19), une résistance (18) peut être branchée par une unité de commutation (5) parallèlement à un filtre de boucle (19, 20).
